# EUROPEAN PATENT APPLICATION

(11) **EP 3 770 984 A1**
(43) Date of publication of application: **27.01.2021**
(21) Application number: 19771467.8
(22) Date of filing: 20.03.2019
(51) Int. Cl.: H01L 51/44, H01L 51/48

(54) **PRODUCTION METHODS FOR SN-BASED PEROVSKITE LAYER AND SOLAR CELL**

(30) Priority: 20.03.2018 JP 2018053418
(71) Applicant: Kyoto University, Kyoto-shi, Kyoto 606-8501 (JP)
(72) Inventor: WAKAMIYA Atsushi, Kyoto-shi, Kyoto 606-8501 (JP); OZAKI Masashi, Kyoto-shi, Kyoto 606-8501 (JP); JIEWEI Liu, Kyoto-shi, Kyoto 606-8501 (JP)
(74) Representative: Moore, Joanne Camilla
(86) International application number: PCT/JP2019/011860
(87) International publication number: WO 2019/182058

(57) **Abstract**

Problem

To provide a production method for a perovskite layer using a tin-based perovskite compound having excellent flatness and a production method for a perovskite-type solar cell using the perovskite layer obtained by the above-described production method for the perovskite layer.

Solution

A method for producing a perovskite layer that includes a step of applying a solution containing an Sn-based perovskite compound to a substrate, a step of applying a poor solvent to the substrate, and a step of performing an annealing process to the substrate, in this order, wherein the poor solvent is at 45°C to 100°C.

## Description

### TECHNICAL FIELD

The present invention relates to production methods for an Sn-based perovskite layer and a solar cell. In more detail, the present invention relates to the production method that allows obtaining an Sn-based perovskite layer having excellent flatness by adjusting a temperature of a poor solvent and quickly stopping a rotation of a substrate after dropping the poor solvent when producing the perovskite layer using an Sn-based perovskite compound.

### BACKGROUND ART

JP-A-2015-138822 discloses the production method of a perovskite-type solar cell including a process that uses a lead halide and an alkylammonium halide as a raw material and forms the perovskite in a light-absorbing layer by a solution method.

A tin-based perovskite compound has been examined as a lead-free perovskite compound. However, currently, no excellent solar cell using the tin-based perovskite compound has been obtained. As shown in test examples described later, in the tin-based perovskite compound, the perovskite layer cannot completely coat a base coat, resulting in unevenness in the perovskite layer that causes, for example, leakage in the uneven portion, which is one of the reasons.

Patent Document 1: JP-A-2015-138822

### DISCLOSURE OF THE INVENTION

### PROBLEMS TO BE SOLVED BY THE INVENTION

The object of the present invention is to provide, for example, a production method for a perovskite layer using a tin-based perovskite compound having excellent flatness, a production method for a perovskite-type solar cell using the perovskite layer obtained by the production method, and a production method of a luminescent element such as an organic EL element.

### SOLUTIONS TO THE PROBLEMS

The present invention described herein is basically based on findings from working examples that flatness of an Sn-based perovskite layer is significantly improved by adjusting temperature of a poor solvent when dropping the poor solvent after applying the Sn-based perovskite compound. Additionally, in a preferred aspect of the present invention, it is based on the findings from the working examples that the flatness of the Sn-based perovskite layer is further improved by quickly stopping rotation of a substrate after dropping the poor solvent when performing spin coating. In an even more preferred aspect, it is based on the findings from the working examples that performing an annealing process in a sealed system where the solvent becomes a saturated vapor pressure enables increasing particle diameters of a perovskite compound, and thus the flatness of a perovskite film to be enhanced.

A production method for a perovskite layer described herein includes a step of applying a solution containing an Sn-based perovskite compound to a substrate, a step of applying a poor solvent to the substrate, and a step of performing an annealing process to the substrate, in this order. In the method, a temperature of the poor solvent when applying the poor solvent to the substrate is 45°C to 100°C. Since the Sn-based perovskite compound is applied to the substrate when applying the poor solvent, applying the poor solvent to the substrate means applying the poor solvent to the substrate in the state where the Sn-based perovskite compound has been applied.

In this method, the temperature of the poor solvent may be 45°C to 85°C, or may be 50°C to 70°C.

As shown in the working examples described later, the step of performing the annealing process preferably includes a step of heating the substrate in stages in a sealed system containing a solvent vapor.

It is preferable that the poor solvent is applied by dropping the poor solvent while rotating the substrate and the rotation is stopped within 2.5 seconds to 7.5 seconds after the poor solvent is applied.

Another aspect of the production method for the perovskite layer herein is a production method for the perovskite layer that includes a step of applying a solution containing an Sn-based perovskite compound to a substrate, a step of applying a poor solvent to the substrate, and a step of performing an annealing process to the substrate, in this order. In the method, the poor solvent is at room temperature or higher, and this facilitates formation of a seed crystal and reduces crystal growth from the seed crystal. Facilitating the formation of the seed crystal and reducing the crystal growth from the seed crystal enables improvement of a coverage and obtainment of the perovskite layer with excellent performance. The production method enables, for example, obtaining a perovskite layer where the coverage of the perovskite layer with the Sn-based perovskite compound is 95% to 100% and an average particle diameter of the perovskite compound is 150 nm to 500 nm.

Another aspect of the production method for the perovskite layer herein is that the coverage of the perovskite layer with the Sn-based perovskite compound is 95% to 100%. As described above, this coverage is achievable by, for example, adjusting the temperature of the poor solvent when applying the poor solvent and annealing conditions.

Another aspect of the production method for the perovskite layer herein relates to a method where the average particle diameter of the perovskite compound is 150 nm to 500 nm. As described above, reducing the crystal growth from the seed crystal and facilitating the formation of the seed crystal enables obtaining the average particle diameter of 150 nm or more and 500 nm or less and a flat and desirable perovskite layer.

After obtaining the perovskite layer by the above-described production method for the perovskite layer, a perovskite-type solar cell can be produced in accordance with an ordinary method. Since the perovskite layer can also be used for producing a luminescent element, such as an organic EL element, after obtaining a perovskite layer by the above-described production method for the perovskite layer, the luminescent element, such as an organic EL element, can be produced by using the perovskite layer.

The next invention described herein relates to a perovskite layer and a perovskite-type solar cell or a luminescent element such as an organic EL element that includes the perovskite layer. The perovskite layer includes the Sn-based perovskite compound and the coverage with the Sn-based perovskite compound is 98% to 100%. In the perovskite layer, it is preferable that the average particle diameter of the Sn-based perovskite compound is 150 nm to 500 nm.

### EFFECTS OF THE INVENTION

With the present invention, it is possible to provide the production method for the perovskite layer using the tin-based perovskite compound having excellent flatness, the production method for the perovskite-type solar cell using the perovskite layer obtained by the production method and the production method for the luminescent element such as an organic EL element.

### BRIEF DESCRIPTION OF THE DRAWINGS

Fig. 1 is a diagram indicating a characteristic of an Sn perovskite solar cell element having a perovskite layer prepared in a test example 1.
Fig. 2 is a diagram indicating a characteristic of an Sn perovskite solar cell element having a perovskite layer prepared in a test example 2 (working example).
Fig. 3 is a photograph that replaces a drawing illustrating a cross-sectional SEM photograph of the Sn perovskite solar cell element having the perovskite layer prepared in the test example 1.
Fig. 4 is a SEM photograph that replaces a drawing of a perovskite film obtained by dropping chlorobenzene at room temperature (rt) of test examples 5.
Fig. 5 is SEM photographs that replace drawings of perovskite layers prepared by dropping chlorobenzene at room temperature (rt) and warmed to 45°C, 65°C, 85°C, and 100°C from the left.
Fig. 6 is a diagram indicating a solar cell characteristic.
Fig. 7 indicates a SEM photograph and measuring results of a fluorescence lifetime in a test example 7. The upper left in Fig. 7 indicates the SEM photograph at room temperature and the down left in Fig. 7 indicates the SEM photograph at 65°C. In the graph on the right side, the graph located at the lower portion is the one at room temperature.
Fig. 8 indicates a SEM photograph and measuring results of the fluorescence lifetime in a test example 8. The upper left in Fig. 8 indicates the SEM photograph at room temperature and the down left in Fig. 8 indicates the SEM photograph at 65°C.
Fig. 9 indicates a SEM photograph and measuring results of the fluorescence lifetime in a test example 9. The upper left in Fig. 9 indicates the SEM photograph at room temperature and the down left in Fig. 9 indicates the SEM photograph at 65°C. In the graph on the right side, the graph located at the lower portion is the one at room temperature.
Fig. 10 is a graph that replaces a drawing indicating a current density-voltage characteristic in a test example 10 (working example).
Fig. 11 is a table indicating the characteristic of the perovskite solar cell in the test example 10 (working example).
Fig. 12 is a graph that replaces a drawing indicating IQE spectrum and EQE spectrum.
Fig. 13 is a cross-sectional SEM photograph of the solar cell obtained by the test example 10.
Fig. 14 is the SEM photograph of the perovskite layer obtained by the test example 10.
Fig. 15 is a SEM image that replaces a drawing of an untreated one.
Fig. 16 is a SEM image that replaces a drawing of the one of a method 1.
Fig. 17 is a SEM image that replaces a drawing of the one of the method 1 + a method 2 (10 seconds).
Fig. 18 is a SEM image that replaces a drawing of the one of the method 1 + the method 2 (30 seconds).
Fig. 19 is a graph that replaces a drawing indicating a fluorescence spectrum of the perovskite thin film of FA_{0.75}MA_{0.25}SnI₃ obtained in a test example 14.
Fig. 20 is a SEM image that replaces a drawing of a FASnBr₃ perovskite thin film obtained in a test example 15.
Fig. 21 is a SEM image that replaces a drawing of the FASnBr₃ perovskite thin film (HAT method) obtained in a test example 16.
Fig. 22 is a graph that replaces a drawing indicating the fluorescence spectrum of the FASnBr₃ perovskite thin film (HAT method) obtained in the test example 16.
Fig. 23 is a graph that replaces a drawing indicating the fluorescence spectrum of an MASnBr₃ perovskite thin film (HAT method) obtained in a test example 17.

### DESCRIPTION OF PREFERRED EMBODIMENTS

The following describes a configuration for executing the present invention. The present invention is not limited to the configuration described below and includes the ones appropriately modified from the configurations described below to the extent apparent to those skilled in the art.

### 1. Production method for Perovskite Layer

The production method for the perovskite layer described herein includes a step of applying a solution containing an Sn-based perovskite compound to a substrate, a step of applying a poor solvent to the substrate, and a step of performing an annealing process to the substrate, in this order. This production method for the perovskite layer can appropriately employ known processes and conditions for producing the perovskite layer.

### 1.1 The following describes the step of applying the solution containing the Sn-based perovskite compound to the substrate.

### 1.1.1 Sn-based Perovskite Compound

The Sn-based perovskite compound itself used for the perovskite layer is publicly known and the Sn-based perovskite compound containing Sn (tin) can also be appropriately used herein.

The example of the Sn-based perovskite compound (also referred to as the perovskite compound of the present invention) herein is a compound shown by a general formula (I).

RSnXⱼ (I)

[in the formula, the oxidation number of Sn is 1.5 to 4, R indicates at least one kind of monovalent cation, X indicates at least one kind of halogen atom, and j indicates 2.5 to 3.5].

The oxidation number of Sn is preferably 1.5 to 3.5 and may be 1.5 to 2.5 or may be 1.5 to 2.

In the general formula (I), R is at least one kind of monovalent cation. R may be two or more kinds of cation. The example of such a monovalent cation is an alkali metal cation and a monovalent transition metal cation.

The alkali metal cation includes, for example, a sodium cation, a potassium cation, a cesium cation, and a rubidium cation.

The monovalent transition metal cation includes, for example, a copper cation, a silver cation, a gold cation, an iron cation, and a ruthenium cation.

The specific example of R is a cation shown as R¹NH³⁺ (R¹ indicates a monovalent substituted or unsubstituted hydrocarbon group). The substituted hydrocarbon group means a hydrocarbon where the hydrogen atom in the hydrocarbon group is substituted by another atom or a substituent. Another specific example of R is a cation represented by Chemical Formula 1.

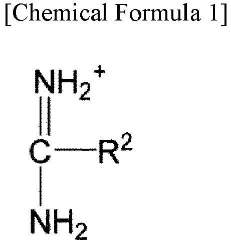

(R² indicates a hydrogen atom, or a monovalent substituted or unsubstituted hydrocarbon group).

The example of "monovalent hydrocarbon group" herein is an alkyl group, an aryl group, or an aralkyl group.

The alkyl group is preferably a linear, branched, or cyclic alkyl group with 1 to 20 carbon atoms. The specific examples of the alkyl group are a methyl group, an ethyl group, a n-propyl group, a 2-propyl group, an n-butyl group, a 1-methyl propyl group, a 2-methyl propyl group, a tert-butyl group, an n-pentyl group, a 1-methyl butyl group, a 1-ethyl propyl group, a tert-pentyl group, a 2-methyl butyl group, a 3-methyl butyl group, a 2,2-dimethyl propyl group, an n-hexyl group, a 1-methyl pentyl group, a 1-ethyl butyl group, a 2-methyl pentyl group, a 3-methyl pentyl group, a 4-methyl pentyl group, a 2-methyl pentane-3-yl group, a 3,3-dimethyl butyl group, a 2,2-dimethyl butyl group, a 1,1-dimethyl butyl group, a 1,2-dimethyl butyl group, a 1,3-dimethyl butyl group, a 2,3-dimethyl butyl group, a 1-ethyl butyl group, a 2-ethyl butyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, an n-icosyl group, a cyclopropyl group, a cyclobutyl group, a cyclopentyl group, and a cyclohexyl group.

The "aryl group" is preferably an aryl group with 6 to 20 carbon atoms. The examples of the aryl group are a phenyl group, an indenyl group, a pentalenyl group, a naphthyl group, an azulenyl group, a fluorenyl group, a phenanthrenyl group, an anthracenyl group, an acenaphthylenyl group, a biphenylenyl group, a naphthacenyl group, and a pyrenyl group.

The "aralkyl group" is preferably an aralkyl group with 7 to 20 carbon atoms. The examples of the aralkyl group are a benzyl group, a phenethyl group, a 1-phenyl propyl group, a 2-phenyl propyl group, a 3-phenyl propyl group, a 1-phenyl butyl group, a 2-phenyl butyl group, a 3-phenyl butyl group, a 4-phenyl butyl group, a 1-phenyl pentyl butyl group, a 2-phenyl pentyl butyl group, a 3-phenyl pentyl butyl group, a 4-phenyl pentyl butyl group, a 5-phenyl pentyl butyl group, a 1-phenyl hexyl butyl group, a 2-phenyl hexyl butyl group, a 3-phenyl hexyl butyl group, a 4-phenyl hexyl butyl group, a 5-phenyl hexyl butyl group, a 6-phenyl hexyl butyl group, a 1-phenyl heptyl group, a 1-phenyl octyl group, a 1-phenyl nonyl group, a 1-phenyl decyl group, a 1-phenyl undecyl group, a 1-phenyl dodecyl group, a 1-phenyl tridecyl group, and a 1-phenyl tetradecyl group.

The examples of the "substituent" are the monovalent hydrocarbon group described above, the halogen atom (for example, a fluorine atom, a chlorine atom, a bromine atom, an iodine atom), -OR^{1a} (R^{1a} indicates the hydrogen atom or the monovalent hydrocarbon group described above), -SR^{1b} (R^{1b} indicates the hydrogen atom or the monovalent hydrocarbon group described above), a nitro group, an amino group, a cyano group, a sulfo group, a carboxy group, a carbamoyl group, an aminosulfonyl group, an oxo group. A count of substituents when having a substituent is not particularly limited, and is preferably 10 or less, more preferably 5 or less, and even more preferably 3 or less.

As the monovalent hydrocarbon group shown as R¹ and R², from the viewpoint that the perovskite material of the present invention easily has a three-dimensional structure, absorbs light in a wider wavelength range, and easily improves an energy conversion efficiency (PCE) and an internal quantum efficiency (IQE), the alkyl group with 1 to 10 carbon atoms, the aryl group with 6 to 20 carbon atoms, and the aralkyl group with 7 to 12 carbon atoms are preferable, the alkyl group with 1 to 6 carbon atoms and the aryl group with 6 to 14 carbon atoms are more preferable, and the alkyl group with 1 to 4 carbon atoms is even more preferable. For the same reason, as R¹ and R², the alkyl group is preferable, the linear or branched alkyl group is more preferable, the linear alkyl group is even more preferable. In particular, the methyl group is most preferable.

As R¹ and R² described above, from the viewpoint that the perovskite compound of the present invention easily has a three-dimensional structure, absorbs light in a wider wavelength range, and easily improves an energy conversion efficiency (PCE) and an internal quantum efficiency (IQE), R¹ is preferably the methyl group and R² is preferably the hydrogen atom. That is, in addition to the alkali metal cation and the monovalent transition metal cation, R is preferably CH₃NH₃⁺ or the following cation.

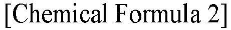

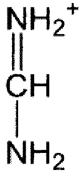

Preferred as R are the groups represented by CH₃NH₃-, (NH₂)₂CH-, and (CH₃NH₃)ₓ((NH₂)₂CH)₁₋ₓ- (x is a number from 0 to 1, preferably 0.1 or more and 0.4 or less, and may be 0.2 or more and 0.3 or less).

In the general formula (I), j is 2.5 to 3.5, and j is preferably 2.8 to 3.2 from the viewpoint of easily improving the energy conversion efficiency (PCE) and the internal quantum efficiency (IQE).

The examples of the perovskite compound of the present invention that satisfy such conditions are tin methylammonium iodide (CH₃NH₃SnI₃: abbreviated as "MASnI₃"), (CH₃NH₃)₂Sn₃I₈: abbreviated as "MA₂Sn₃I₈," tin methyl ammonium bromide (CH₃NH₃SnBr₃: abbreviated as "MASnBr₃"), tin holm amidinium iodide ((NH₂)₂CHSnI₃: abbreviated as "FASnI₃"), and tin holm amidinium bromide ((NH₂)₂CHSnBr₃: abbreviated as "FASnBr₃"), FA₁₋ₓMAₓSnI₃ (x is a number from 0 to 1, preferably 0.1 to 0.4, and may be 0.2 to 0.3), CsSnI₃, CsSnBr₃ and a mixture of these. Of these, FA_{0.75}MA_{0.25}SnI₃, MASnI₃ and FASnI₃ are preferable.

### 1.1.2 Solution Containing Sn-Based Perovskite Compound

A solution containing the Sn-based perovskite compound can be basically obtained by dissolving a tin halide and a compound to be a halogenated cation source in a solvent. The solvent is preferably a polar solvent. The examples of the compound to be the halogenated cation source are FAI, MAI, FABr, MABr, FA₁₋ₓMAₓI, FA₁₋ₓMAₓBr and a mixture of these. The molar ratio of "the tin halide" to "the compound which is the halogenated cation source" may be 1:3 to 3:1, may be 1:2 to 2:1, may be 3:2 to 2:3, and may be 3:4 to 4:3.

The solvent is preferably a solvent having a boiling point of about 35°C to 250°C. The example of the solvent includes, for example, N,N-dimethylformamide (DMF), dimethyl sulfoxide (DMSO), sulfolane, N-methyl pyrrolidone, propylene carbonate, α-acetyl-γ-butyrolactone, tetramethylene sulfoxide, ethyl cyanoacetate, acetyl acetone, 3-methoxy N,N-dimethylpropane amide, N,N'-dimethyl ethylene urea, 1,1,3,3-tetramethyl urea, 2-acetyl cyclohexanone, 1,3-dimethyl-3,4,5,6-tetrahydro-2(1H)-pyrimidinone, 3,4-dyhidro-1(2H)-naphthalenone, cyclopentanone, cyclohexanone, cycloheptanone, aniline, piperidine, pyridine, 4-tert-butylpyridine, 4-amylpyridine, 4-aminopyridine, 2-amylpyridine, 4-methylpyridine, pentafluoropyridine, 2,4,6-tetramethylpyridine, 2,6-di-tert-butyl-4-methylpyridine, 4-pyridine ethylamine, cyclooctenone, 2,5-dimethoxy tetrahydrofuran, 1,4,7,10-tetraoxacyclododecane, ethyl p-toluate, 1,2-dimethoxybenzene, tetrahydrofurfuryl acetate, cyclohexyl acetate, cyclopentyl methyl ether, phenyl ethylamine, ethylenediamine, triethylamine, diisopropylethylamine, hydrazine. Of these, N, N-dimethylformamide (DMF) or dimethylsulfoxide (DMSO) is preferable from the viewpoint of forming a coordinate bond at the center of the metal.

The example of a concentration of the tin halide in the solvent is 0.1 mol/L to 5 mol/L (or 0.5 mol/L to 3 mol/L). A solution containing the Sn-based perovskite compound can be acquired by appropriately mixing the above-described compound with the above-described solvent. If necessary, it is only necessary to appropriately stir and heat the solvent to dissolve the compound.

### Substrate

As the substrate, a known substrate in a perovskite-type solar cell or an organic EL element can be appropriately used. The examples of the substrate are a glass substrate, an insulator substrate, a semiconductor substrate, a metal substrate, and a conductive substrate (including a conductive film). A substrate having a part or all of these surfaces which at least one kind of film of a metal film, a semiconductor film, a conductive film, and an insulating film is formed on a part or all of these surfaces can also be preferably used.

The example of the constituent metal of the metal film is one kind of metals or two or more kinds of metals selected from gallium, iron, indium, aluminum, vanadium, titanium, chrome, rhodium, nickel, cobalt, zinc, magnesium, calcium, silicon, yttrium, strontium, and barium. The examples of the constituent material of the semiconductor film include, for example, a single substance of element such as silicon, germanium, a compound that has an element of the group 3 to the group 5, the group 13 to the group 15 of the periodic table, a metal oxide, a metal sulfide, a metal selenide, and a metal nitride. The examples of the constituent material of the conductive film are tin-doped indium oxide (ITO), fluorine-doped indium oxide (FTO), zinc oxide (ZnO), aluminum-doped zinc oxide (AZO), gallium-doped zinc oxide (GZO), tin oxide (SnO₂), indium oxide (In₂O₃), and tungsten oxide (WO₃). The examples of the constituent material of the insulating film are aluminum oxide (Al₂O₃), titanium oxide (TiO₂), silicon oxide (SiO₂), silicon nitride (Si₃N₄), and silicon oxynitride (Si₄O₅N₃).

The examples of the shape of the substrate are plate-shaped such as a flat plate or a circular plate, fibrous-shaped, bar-shaped, column-shaped, prism-shaped, tube-shaped, spiral-shaped, sphere-shaped, or ring-shaped, and the substrate may have a porous structure. Of these, the plate-shaped substrate is preferred. The example of the thickness of the substrate is preferably 0.1 µm to 100 mm, more preferably 1 µm to 10 mm.

Step of Applying Solution Containing Sn-Based Perovskite Compound to Substrate.

When the solution containing the Sn-based perovskite compound is applied to the substrate, a semiconductor layer as a base coat layer may be formed on the substrate. In that case, applying the solution containing the Sn-based perovskite compound to the substrate means a step of applying the solution containing the Sn-based perovskite compound to the substrate (on the base coat layer) where the base coat layer is formed.

It is only necessary to use a spin coating, a dip coating, a screen-printing method, a roll coating, a die coating method, a transfer printing method, a spray method, or a slit coating for applying the solution containing the Sn-based perovskite compound to the substrate. Of these, applying the solution on the substrate by the spin coating is preferred. The spin coating is a method where a solution is dropped and applied onto a substrate while rotating the substrate. The substrate with the solution onboard may be rotated to apply the solution onto the substrate. It is only necessary that a rotation speed is such that a maximum speed is 1,000 rpm to 10,000 rpm for 30 seconds to 5 minutes, it is from 2 seconds to 15 seconds up to the maximum speed, and it is from 2 seconds to 15 seconds from the maximum speed to a stop.

### 1.2. Step of Applying Poor Solvent to Substrate

Next, the following describes a step of applying a poor solvent to a substrate.

The poor solvent means a solvent that has an ability to dissolve a solute but does not have high solubility of the solute. The example of the poor solvent includes, for example, a substituted aliphatic hydrocarbon such as dichloromethane, chloroform; an aromatic hydrocarbon such as toluene, benzene; a substituted aromatic hydrocarbon such as chlorobenzene, ortho-dichlorobenzene, nitrobenzene; ether such as acetic acid, diethyl ether, tetrahydrofuran (THF); alcohol such as methanol, ethanol, isopropanol, butanol, octanol; a long-chain hydrocarbon (in particular, C4 to C10 hydrocarbons) such as hexane; and acetonitrile. These poor solvents can be used alone and can be used in combination of two or more kinds. Of these, chlorobenzene or toluene is preferred.

The poor solvent may be used alone or as a mixture with a polar solvent. When the poor solvent is mixed with the polar solvent, the ratio of the polar solvent to the poor solvent is preferably poor solvent/polar solvent = 2.0 to 10.0/1.0 (volume ratio), more preferably 3.0 to 8.0/1.0 (volume ratio).

Since the Sn-based perovskite compound is applied to the substrate when applying the poor solvent, applying the poor solvent to the substrate means applying the poor solvent to the substrate in the state where the Sn-based perovskite compound has been applied. The method of applying the poor solvent to the substrate is similar to the method of applying the Sn-based perovskite compound. When the spin coating of the Sn-based perovskite compound is performed, the poor solvent may be dropped to the substrate to apply the poor solvent to the substrate. It is only necessary that the amount of the poor solvent to be applied is appropriately adjusted. The volume ratio of the poor solvent to the solution containing the Sn-based perovskite compound may be 1:10 to 2:1, or may be 1:5 to 1:1.

The temperature of the poor solvent when the poor solvent is applied to the substrate is 45°C to 100°C. Under the conditions shown in the working examples described later, using the poor solvent with this temperature enables reduced crystal growth from a seed crystal and facilitated formation of the seed crystal, resulting in filling the Sn-based perovskite layer, reducing unevenness of the Sn-based perovskite layer, and obtaining the flat and a pore free Sn-based perovskite layer.

In this method, the temperature of the poor solvent may be 45°C to 85°C, or may be 50°C to 70°C. This temperature allows the Sn-based perovskite compound to grow without damaging the base coat layer. It is only necessary that the temperature of the poor solvent is appropriately adjusted corresponding to, for example, the kind of the Sn-based perovskite compound.

It is preferable that the poor solvent is applied by dropping the poor solvent while rotating the substrate and the rotation is stopped within 2.5 seconds to 7.5 seconds (for example, 3 seconds to 7 seconds, 4 seconds to 6 seconds) after the poor solvent is applied. As demonstrated by the working example described later, after dropping the poor solvent, stopping the rotation extremely quickly allows adjustment of the state of the Sn-based perovskite compound. Conventionally, usually, the rotation of the substrate is decelerated after maintaining the rotation speed for about 30 seconds after dropping the poor solvent. In this description, as shown in the working examples described later, it is preferable to start deceleration of the rotation speed of the substrate within 10 seconds immediately after the completion of dropping the poor solvent (within 5 seconds immediately after the completion, within 3 seconds immediately after the completion, within 2 seconds immediately after the completion, within 1 second immediately after the completion, or immediately after the completion). This ensures reduced variation of the characteristics inside the perovskite layer (film).

It is preferable to perform the step of applying the solution containing the Sn-based perovskite compound and the step of applying the poor solvent in a sealed system similarly to a step of an annealing process described later. In the sealed system, it is preferable that the vapor of the solvent contained in the solution containing the Sn-based perovskite compound is present, and more preferably, it is preferable that the solvent has a saturated vapor pressure or a partial pressure of 90% or more of the saturated vapor pressure inside the sealed system.

### 1.3. Step of Performing Annealing Process to Substrate

Next, the step of performing an annealing process to the substrate will be described. The annealing process means a process of, for example, heating the substrate. The annealing step is preferably performed promptly after dropping the poor solvent, or after the substrate is stopped. As shown in the working example described later, the step of performing annealing process preferably includes a step of heating the substrate in stages in the sealed system containing a solvent vapor. In the sealed system, it is preferable that the vapor of the solvent contained in the solution containing the Sn-based perovskite compound is present, and more preferably, it is preferable that the solvent has the saturated vapor pressure or the partial pressure of 90% or more of the saturated vapor pressure inside the sealed system.

In the step of performing annealing process to the substrate, it is preferable to raise the temperature in two or more stages. As demonstrated by the working example, raising the temperatures in multiple stages in that manner allows facilitating the growth of the Sn-based perovskite compound, increasing the particle sizes, and thus filling the Sn-based perovskite layer.

The case where the annealing process includes multiple stages means that after the substrate temperature is raised to a plurality of target temperatures, the substrate temperature is maintained at the set temperature for a predetermined time, and then raised to the next set temperature.

The example of the set temperature of the first stage is 30°C or higher and 60°C or lower, and may be 35°C or higher and 55°C or lower, or may be 40°C or higher and 50°C or lower.

A residence time of the set temperature of the first stage may be 5 seconds or more and 1 minute or less, or may be 5 minutes or more and 20 minutes or less.

The set temperature of the second stage is preferably higher than the set temperature of the first stage. The example of the set temperature of the second stage is 50°C or higher and 80°C or lower, and may be 55°C or higher and 75°C or lower, or may be 60°C or higher and 70°C or lower.

The residence time of the set temperature of the second stage may be 5 seconds or more and 1 minute or less, or may be 5 minutes or more and 30 minutes or less, or may be 5 minutes or more and 20 minutes or less, or may be 10 minutes or more and 20 minutes or less.

The set temperature of the third stage (when the first stage or the second stage is omitted, the set temperature of the second stage) is preferably higher than that of the first stage or the second stage. The example of the set temperature of the third stage is 70°C to 120°C, and may be 80°C to 110°C, or may be 90°C to 110°C.

The residence time of the set temperature of the third stage may be 5 seconds to 1 minute, or may be 5 minutes to 20 minutes.

The example of the film thickness of the perovskite layer from which the perovskite layer can be obtained in this way is 10 nm to 1,000 nm. The film thickness may be 50 nm to 500 nm, or may be 100 nm to 500 nm, or may be 250 nm to 500 nm.

After the perovskite layer is obtained by the production method for the perovskite layer described above, a perovskite-type solar cell can be manufactured in accordance with an ordinary method. In fact, because the perovskite layer can be also used for producing an organic EL element, after obtaining a perovskite layer by the production method for the perovskite layer described above, the organic EL element can be produced using the perovskite layer.

The next invention described herein relates to a perovskite layer and a perovskite-type solar cell containing the perovskite layer. The perovskite layer includes the Sn-based perovskite compound and a coverage with the Sn-based perovskite compound is preferably 95% to 100%. The coverage is more preferably 98% to 100%, even more preferably 99% to 100%. In fact, as long as the characteristics are not impaired, even if the coverage is 95% to 100%, the coverage is higher than the coverage in the case of production based on the prior art, which is preferable. In this perovskite layer, an average particle diameter of the Sn-based perovskite compound is preferably 150 nm to 500 nm. It is only necessary to calculate the coverage from an area obtained by taking a SEM image. Specifically, the coverage may be obtained by using image analysis software, alternatively the coverage, which is a proportion of an area of a substrate covered by the perovskite compound, may be obtained by surrounding an blackened area, which is not covered by the perovskite compound, and then obtaining the area of the surrounded portion. Also, to obtain the average particle diameter of the Sn-based perovskite compound, it is only necessary to photograph the Sn-based perovskite layer to obtain the average size (for example, an average value of the maximum lengths of an interface) using the interface of the Sn-based perovskite compound. It is only necessary to employ an arithmetic mean value for the average particle diameter.

### 2. Perovskite-Type Solar Cell

The perovskite-type solar cell includes, for example, a transparent electrode, a (positive hole) blocking layer, an electron transport layer, a perovskite layer (light absorbing layer), a hole transport layer, and a metal electrode, in this order. The perovskite-type solar cell may be a conventional type where an n-type semiconductor layer is located on the transparent electrode, or may be an inverted type where a p-type semiconductor layer is located on the transparent electrode. The following describes the perovskite-type solar cell taking a perovskite-type solar cell including the transparent electrode, the (positive hole) blocking layer, the electron transport layer, the perovskite layer (light absorbing layer), the hole transport layer, and the metal electrode in this order as an example.

### 2.1 Transparent Electrode

The transparent electrode is a support for the electron transport layer and is a layer having a function of extracting current (electrons) from the perovskite layer (light absorbing layer) via the (positive hole) blocking layer, and thus the transparent electrode is preferably a conductive substrate, and is preferably a transparent conductive layer having translucency capable of transmitting light that contributes to photoelectric conversion.

The transparent conductive layer includes, for example, a tin-doped indium oxide (ITO) film, an impurity-doped indium oxide (In₂O₃) film, an impurity-doped zinc oxide (ZnO) film, a fluorine-doped tin dioxide (FTO) film, and a laminated film made by laminating these films. The thickness of these transparent conductive layer is not specifically limited, and it is preferable that the electric resistance is ordinarily adjusted to be 5 Ω to 15 Ω/□. The transparent conductive layer can be obtained by a known film forming method depending on a material to be formed.

To protect from the outside, the transparent conductive layer can be covered by a translucent coating body as needed. The translucent coating body includes, for example, a resin sheet such as fluororesin, polyvinyl chloride, polyimide; an inorganic sheet such as a white sheet glass, a soda glass; and a hybrid sheet composed of a combination of these materials. The thicknesses of these translucent coated bodies are not specifically limited, and it is preferable that the electric resistance is ordinarily adjusted to be 5 Ω to 15 Ω/□.

### 2.2 (Positive Hole) Blocking Layer

The (positive hole) blocking layer is a layer located to reduce leakage of the positive hole and suppress a reverse current to improve the solar cell characteristic (in particular, photoelectric conversion efficiency), and is preferably located between the transparent electrode and the perovskite layer (light-absorbing layer). The (positive hole) blocking layer is preferably a layer composed of a metal oxide such as a titanium oxide, and is more preferably a layer that smoothly and densely covers the surface of the transparent electrode with the n-type semiconductor such as compact TiO₂. The term "dense" means that a metal compound is filled at a density higher than the filling density of the metal compound in the electron transport layer. When the transparent electrode and the electron transport layer are not electrically coupled, for example, pinholes or cracks may be present.

The film thickness of the (positive hole) blocking layer is, for example, 5 nm to 300 nm. The film thickness of the (positive hole) blocking layer is more preferably 10 nm to 200 nm from the viewpoint of electron injection efficiency into the electrode.

The (positive hole) blocking layer is formed on the above-described transparent electrode. When a metal oxide is used for the (positive hole) blocking layer, the (positive hole) blocking layer can be produced by performing spray pyrolysis in accordance with a known method (for example, non-patent document 4, J. Phys. D: Appl. Phys. 2008, 41, 102002.). For example, the (positive hole) blocking layer can be produced by spraying an alcohol solution (for example, an isopropyl alcohol solution) of 0.01 M to 0.40 M (specifically, 0.02 M to 0.20 M) metal alkoxide (for example, titanium alkoxide such as titanium di-isopropoxide bis(acetylacetonate)) on a transparent electrode placed on a hot plate heated to 200°C to 550°C (specifically, 300°C to 500°C).

After that, a more dense film can be made by immersing and heating the obtained substrate in an aqueous solution of titanium oxide (for example, TiO₂), titanium alkoxide (for example, titanium isopropoxide), and a titanium halide (for example, TiCl₄).

The concentration of the material in the aqueous solution containing the material of the (positive hole) blocking layer is preferably 0.1 mM to 1.0 mM, more preferably 0.2 mM to 0.7 mM. The immersion temperature is preferably 30°C to 100°C, more preferably 50°C to 80°C. Additionally, the heating conditions are preferably 200°C to 1,000°C (particularly, 300°C to 700°C) for 5 minutes to 60 minutes (particularly, 10 minutes to 30 minutes).

### 2.3 Electron Transport Layer

The electron transport layer is formed to increase an active surface area of the perovskite layer (light-absorbing layer), improve the photoelectric conversion efficiency, and facilitate electron collection. The electron transport layer may be formed on the substrate, and is preferably formed on the (positive hole) blocking layer. The above-described (positive hole) blocking layer may function as the electron transport layer, and the electron transport layer may also serve as the (positive hole) blocking layer. The electron transport layer may be a flat layer using an organic semiconductor material such as a fullerene derivative. The electron transport layer may be a titanium oxide (TiO₂) (including mesoporous TiO₂), an SnO₂ layer, or a ZnO layer. The electron transport layer preferably has a porous structure such as mesoporous TiO₂. As for the porous structure, for example, it is preferable that a granular body, a needle-shaped body, a tube-shaped body, and a pillar-shaped body are aggregated to entirely have a porous property. A pore size is preferably nanoscale. Having a porous structure and being nanoscale significantly increases the active surface area of the light absorbing layer, improves the solar cell characteristic (particularly, photoelectric conversion efficiency), and can create a porous electron transport layer excellent in electron collection.

The electron transport layer may be a layer composed of the metal oxide such as the titanium oxide or tin oxide. When the metal compound is a semiconductor, a donor can also be doped when using the semiconductor. This allows the electron transport layer to become a window layer for introducing into the perovskite layer (light-absorbing layer), and to take out the electric power obtained from the perovskite layer (light-absorbing layer) more efficiently.

The thickness of the electron transport layer is not particularly limited, and is preferably about 10 nm to 300 nm, more preferably about 10 nm to 250 nm, from the viewpoint of being able to collect more electrons from the perovskite layer (light-absorbing layer). The electron transport layer can be obtained using a known film forming method in accordance with the material to be formed. For example, the electron transport layer can be produced by applying an alcohol solution (for example, an ethanol solution) of a titanium oxide paste having 5 mass% to 50 mass% (particularly, 10 mass% to 30 mass%) onto the (positive hole) blocking layer. As the titanium oxide paste, a known or commercially available product can be used. As the coating method, the spin coating method is preferable. The application can be performed at, for example, about 15°C to 30°C.

### 2.3 Perovskite Layer (Light-Absorbing Layer)

The perovskite layer (light-absorbing layer) in a perovskite-type solar cell is a layer that performs photoelectric conversion by absorbing light and moving excited electrons. The perovskite layer (light-absorbing layer) includes a perovskite material and a perovskite complex. It is only necessary to manufacture the perovskite layer based on the method described above. As for the perovskite layer, mass production by roll-to-roll is preferably achieved. It is preferable to apply the mixed solution on the substrate by, for example, the spin coating, the dip coating, the screen-printing method, the roll coating, the die coating method, the transfer printing method, the spray method, and the slit coating method, preferably by the spin coating.

The film thickness of the perovskite layer (light-absorbing layer) is preferably, for example, 50 nm to 1,000 nm, more preferably 200 nm to 800 nm from the viewpoint of a balance between light absorption efficiency and an exciton diffusion length, and absorption efficiency of light reflected by the transparent electrode. The film thickness of the perovskite layer (light-absorbing layer) of the present invention is preferably within a range of 100 nm to 1,000 nm, more preferably within a range of 250 nm to 500 nm. Specifically, a lower limit value of the film thickness of the perovskite layer (light-absorbing layer) of the present invention is preferably 100 nm or more (particularly, 250 nm or more) and an upper limit value is preferably 1,000 nm or less (particularly, 500 nm or less). The film thickness of the perovskite layer (light-absorbing layer) of the present invention is measured with a cross-section scanning electron microscope (cross-section SEM) of a film composed of the complex of the present invention.

As for the flatness of the perovskite layer (light-absorbing layer) of the present invention, height difference in a horizontal range of 500 nm x 500 nm of the surface measured by a scanning electron microscope is preferably 50 nm or less (- 25 nm to + 25 nm), the height difference is more preferably 40 nm or less (- 20 nm to + 20 nm). This allows taking easier balance between the light absorption efficiency and the exciton diffusion length and improving absorption efficiency of light reflected by the transparent electrode. In the flatness of the perovskite layer (light-absorbing layer), a measurement point determined optionally is used as a reference point, and the upper limit value is the difference between the largest film thickness and the film thickness at the reference point in the measurement range, and the lower limit value is the difference between the smallest film thickness and the film thickness at the reference point. The measurement is performed by the cross-section scanning electron microscope (cross-section SEM) of the perovskite layer (light-absorbing layer) of the present invention.

### 2.4. Hole Transport Layer

The hole transport layer is a layer having a function of transporting electric charges. For the hole transport layer, for example, a conductor, a semiconductor, and an organic positive hole transport material can be used. The material can function as a positive hole transport material that receives the positive holes from the perovskite layer (light-absorbing layer) and transports the positive holes. The hole transport layer is formed on the perovskite layer (light-absorbing layer). The conductor and semiconductor include, for example, a compound semiconductor including a monovalent copper such as Cul, CuInSe₂, CuS; and a compound including a metal other than copper, such as GaP, NiO, CoO, FeO, Bi₂O₃, MoO₂, and Cr₂O₃. Of these, from the viewpoint of receiving only positive holes more efficiently and obtaining higher hole mobility, the semiconductor containing monovalent copper is preferable, and CuI is more preferable. The organic positive hole transport material includes, for example, a polythiophene derivative such as poly-3-hexylthiophene (P3HT), polyethylene dioxythiophene (PEDOT); a fluorene derivative such as 2,2',7,7'-tetrakis-(N,N-di-p-methoxyphenyl amine)-9,9'-spirobifluorene (spiro-OMeTAD); a carbazole derivative such as polyvinyl carbazole; a triphenylamine derivative such as poly [bis(4-phenyl)(2,4,6-trimethylphenyl) amine](PTAA); a diphenylamine derivative; a polysilane derivative; and a polyaniline derivative. Of these, from the viewpoint of receiving only positive holes more efficiently and obtaining higher hole mobility, for example, the triphenylamine derivative and the fluorene derivative are preferable, and, for example, PTAA and spiro-OMeTAD are more preferable.

To further improve the positive hole transport characteristic, the hole transport layer can also include an oxidizing agent such as lithium bis(trifluoromethylsulfonyl)imide (LiTFSI), silver bis(trifluoromethylsulfonyl)imide, trifluoromethylsulfonyloxy silver, NOSbF₆, SbCl₅, and SbFs. The hole transport layer can also include a basic compound such as t-butyl pyridine (TBP), 2-picoline, 2,6-lutidine. The content of the oxidizing agent and the basic compound can be the amount normally used conventionally. The film thickness of the hole transport layer is preferably, for example, 30 nm to 200 nm, and more preferably 50 nm to 100 nm from the viewpoint of receiving only positive holes more efficiently and obtaining higher positive hole mobility. The method of forming a film of the hole transport layer is preferably performed, for example, under a dry atmosphere. For example, it is preferable to apply (for example, spin coating) the solution containing the organic positive hole transport material on the perovskite layer (light-absorbing layer) under the dry atmosphere and heat at 30°C to 150°C (particularly, 50°C to 100°C).

### 2.5. Metal Electrode

The metal electrode is arranged opposite to the transparent electrode and is formed on the hole transport layer so that electric charges can be exchanged with the hole transport layer. As the metal electrode, a known material used in the art can be used, for example, the material includes the metal such as platinum, titanium, stainless steel, aluminum, gold, silver, and nickel, or an alloy of these metals. Of these, as the electrode can be formed under a dry atmosphere, the material with which the metal electrode can be formed by a method such as vapor deposition is preferable. A perovskite-type solar cell having a structure other than the above-described layer structure can also be produced by a similar method.

### 3. Organic Electroluminescence Element (Organic EL Element)

The organic EL element is a known element as disclosed in, for example, JP-A-2017-123352 and JP-A-2015-071619, and the production method for the organic EL element is also known. The example of the organic EL element has a substrate, an anode, a cathode, and an organic layer arranged between the anode and the cathode. The organic layer is composed of a positive hole injection layer, a hole transport layer, a luminescent layer, an electron transport layer, and an electron injection layer that are laminated in this order from the anode side. The compound of the present invention can be used as the electron transport material in the electron transport layer. The organic EL element is an example of the perovskite-type luminescent element containing the perovskite layer. The present invention provides the perovskite-type luminescent element containing the perovskite layer and the production method for the perovskite-type luminescent element.

### 4. The present invention also provides the production method for the solar cell.

The method includes a step of forming the electron transport (blocking) layer on the substrate, a step of forming the perovskite layer on the electron transport layer, a step of forming the hole transport layer on the perovskite layer, and a step of forming the electrodes on the hole transport layer, using the above-described production method for the perovskite layer. The present invention also provides the perovskite-type solar cell containing the perovskite layer.

### [Working Example]

J-V characteristic of the solar cell characteristic and an IPCE spectrum each were measured using an OTENTO-SUN-P1G-type solar light irradiation light source device, and an SM-250-type spectral sensitivity measurement device manufactured by BUNKOUKEIKI Co., Ltd. The SEM images were measured using HITACHI S4800. By using a picosecond laser with a wavelength of 510 nm obtained from supercontinuum light source (Fianium Ltd.) as an excitation light, the emission light was detected and recorded, and the fluorescence lifetime characteristic was obtained using an avalanche photodiode (iDQ) and a time correlated single light measurement board (Becker & Hickl GmbH).

### Test Example 1: PEDOT: PSS Formed on ITO Glass Substrate (PEDOT: PSS/ITO Glass Substrate)

The ITO glass substrate (geomatic, 5 Ω, 0001) patterned with zinc powder and 6N hydrochloric acid was ultrasonically cleaned in the order of a neutral detergent, acetone, and 2-propanol for 10 minutes, respectively. After drying the substrate using an air gun, UV ozone cleaning was performed for 15 minutes. On the obtained ITO glass substrate, 500 µL of PEDOT:PSS aqueous solution (Clevious P VP. AI 4083 manufactured by Heraeus) was placed and then spin-coated (slope 1 second, 500 rpm for 9 seconds, slope 1 second, 4,000 rpm for 60 seconds, slope 1 second). Then, by annealing at 140°C for 20 minutes, a PEDOT:PSS layer having a film thickness of 20 nm to 30 nm was formed.

### Test Example 2: Formation of Perovskite Layer

Inside a glove box, SnI₂ (595 mg, 1.6 mmol), FAI (206 mg, 1.2 mmol), MAI (63 mg, 0.4 mmol), SnF₂ (25 mg, 0.16 mmol) were dissolved in super-dehydrated DMSO (2.0 mL) at 45°C. After stirring for one hour at 45°C, the solution was filtered using a PTFE filter to prepare a 0.8 M solution of FA_{0.75}MA_{0.25}SnI₃. Then, 200 µL of this solution was placed on the PEDOT:PSS/ITO glass substrate and spin-coated (slope 5 seconds, 5,000 rpm for 90 seconds, slope 5 seconds). After rotating the substrate at 5,000 rpm for 60 seconds, 500 µL of chlorobenzene was dropped, and the perovskite layer turned brown. Then, the brown perovskite discolored to colorless and transparent while rotating further 30 seconds at 5,000 rpm. Then, the rotation of the substrate was stopped, which took 5 seconds. The obtained colorless transparent film was annealed (100°C, 10 minutes) on the hot plate to obtain a black perovskite film.

### Test Example 3: Improvement of Test Example 2 (Quick Stopping)

### Development of Method for Suppressing Discoloration (slope 5 seconds, 5,000 rpm for 60 seconds, slope 5 seconds) by Stopping Spin Coating before Discoloration, after Dropping Chlorobenzene

Inside a glove box, SnI₂ (595 mg, 1.6 mmol), FAI (206 mg, 1.2 mmol), MAI (63 mg, 0.4 mmol), SnF₂ (25 mg, 0.16 mmol) were dissolved in super-dehydrated DMSO (2.0 mL) at 45°C. After stirring for one hour at 45°C, the solution was filtered using a PTFE filter to prepare a 0.8 M solution of FA_{0.75}MA_{0.25}SnI₃. Then, 200 µL of this solution was placed on the PEDOT:PSS/ITO glass substrate and spin-coated (slope 5 seconds, 5,000 rpm for 60 seconds, slope 5 seconds). When 500 µL of chlorobenzene was dropped after 60 seconds at 5,000 rpm, the perovskite layer turned brown. Immediately after the dropping, the speed was reduced, and the spin was stopped, which took 5 seconds. The obtained brown film was placed on a hot plate and annealed (100°C, 10 minutes) to obtain a black perovskite film.

### Test Example 4: Production of Device

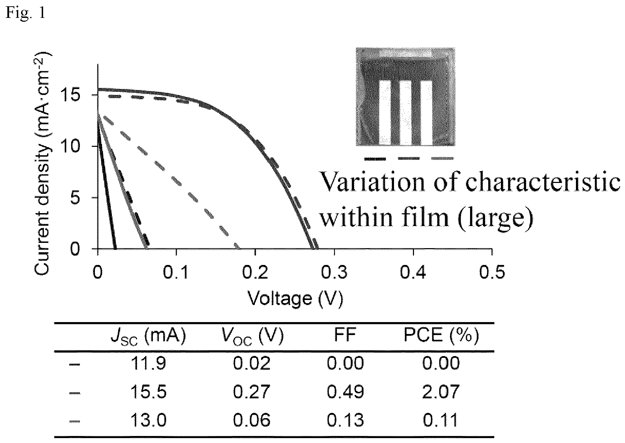

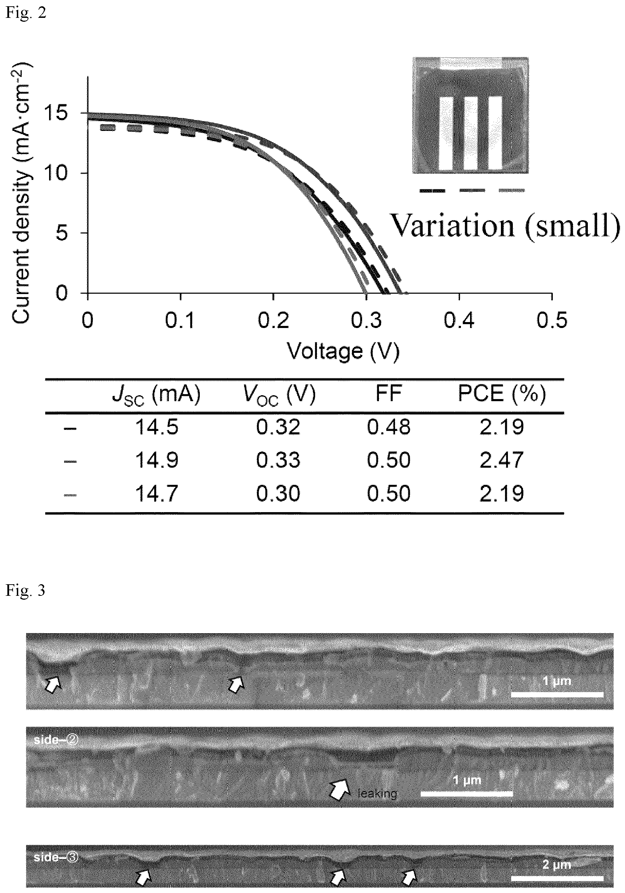

C₆₀ (50 nm (rate: 0.1 angstrom/second 0 nm to 10 nm, 0.2 angstrom/second 10 nm to 20 nm, 0.5 to 1.0 angstrom/second 20 nm to 50 nm)), BCP (8 nm (rate: 0.1 to 0.2 angstrom/second 0 nm to 8 nm)), Ag (100 nm (rate: 0.1 angstrom/second 0 nm to 10 nm, 0.2 angstrom/second 10 nm to 20 nm, 0.5 to 1.0 angstrom/second 20 nm to 100 nm)) was laminated on the perovskite film obtained in the test examples 2 and 3 by vacuum deposition to produce the Sn perovskite solar cell element. The solar cell characteristic (J-V) of these solar cell elements was evaluated under an inert gas atmosphere. Fig. 1 is a diagram indicating a characteristic of the Sn perovskite solar cell element having the perovskite layer prepared in the test example 1. Fig. 2 is a diagram indicating a characteristic of the Sn perovskite solar cell element having the perovskite layer prepared in the test example 2 (working example). Fig. 3 is a photograph that replaces a drawing illustrating a cross-sectional SEM photograph of the Sn perovskite solar cell element having the perovskite layer prepared in the test example 1.

As shown in Fig. 1, the Sn perovskite solar cell element having the perovskite layer prepared in the test example 1 obtains an efficiency of only about 2% at the maximum, and the characteristic varied widely even within the same device such that there were places where the efficiency was 0%. As shown in Fig. 3, in the Sn perovskite solar cell element having the perovskite layer prepared in the test example 1, many points where the PEDOT:PSS layer as the base coat layer and the C₆₀ layer as the upper base coat layer were in contact were observed by cross-sectional SEM observation. As a result of cross-sectional SEM, it was clarified that the film thickness of the perovskite layer was 0 nm to 160 nm.

Meanwhile, as shown in Fig. 2, the Sn perovskite solar cell element having the perovskite layer prepared in the test example 2 (working example) achieved an average efficiency of about 2%, and the variation between different electrodes in the same device was relatively small.

### Test Example 5: Temperature Effect of Chlorobenzene and Surface SEM Observation

Inside a glove box, SnI₂ (1788 mg, 4.8 mmol; Aldrich), FAI (619 mg, 3.6 mmol), MAI (191 mg, 1.2 mmol), SnF₂ (75 mg, 0.48 mmol) were dissolved in super-dehydrated DMSO (6.0 mL) at 45°C. After stirring for one hour, the solution was filtered using a PTFE filter to prepare a 0.8 M solution of FA_{0.75}MA_{0.25}SnI₃. Then, 200 µL of this solution was placed on the PEDOT:PSS/ITO glass substrate and spin-coated (slope 5 seconds, 5,000 rpm for 60 seconds, slope 1 second). After 58 seconds at a rotation speed of 5,000 rpm, 300 µL of chlorobenzene at room temperature or warmed to 45°C, 65°C, 85°C, 100°C using a hot plate, respectively, was dropped. Then, the obtained film was annealed (10 minutes at 45°C, >10 minutes or more at 65°C, 10 minutes at 100°C) to obtain a black perovskite film.

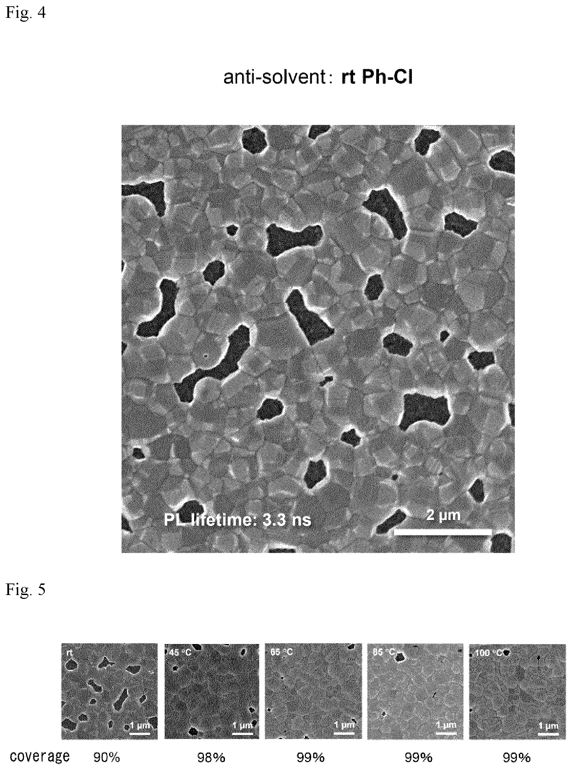

Fig. 4 is a SEM photograph that replaces a drawing of the perovskite film obtained by dropping chlorobenzene at room temperature (rt) of the test examples 5. As shown in Fig. 4, when the SEM observation of the obtained film was performed, many defects were observed in the perovskite layer prepared by dropping chlorobenzene at room temperature, and the surface coverage calculated from the area of the SEM image was about 90%. Fig. 5 is SEM photographs that replace drawings of perovskite layers prepared by dropping chlorobenzene at room temperature (rt) and warmed to 45°C, 65°C, 85°C, and 100°C from the left. As shown in Fig. 5, the perovskite layer prepared by dropping chlorobenzene at 45°C to 100°C had relatively high flatness and a high coverage. The surface coverage calculated from the area of the SEM image in the range of 10 µm square was 98% when the dropped chlorobenzene was 45°C, and 99% when it was 65°C to 100°C. When the fluorescence lifetime was measured for each film, all the fluorescence lifetime was about 4 nanoseconds.

### Test Example 6: Temperature Dependance of Chlorobenzene and Device Efficiency

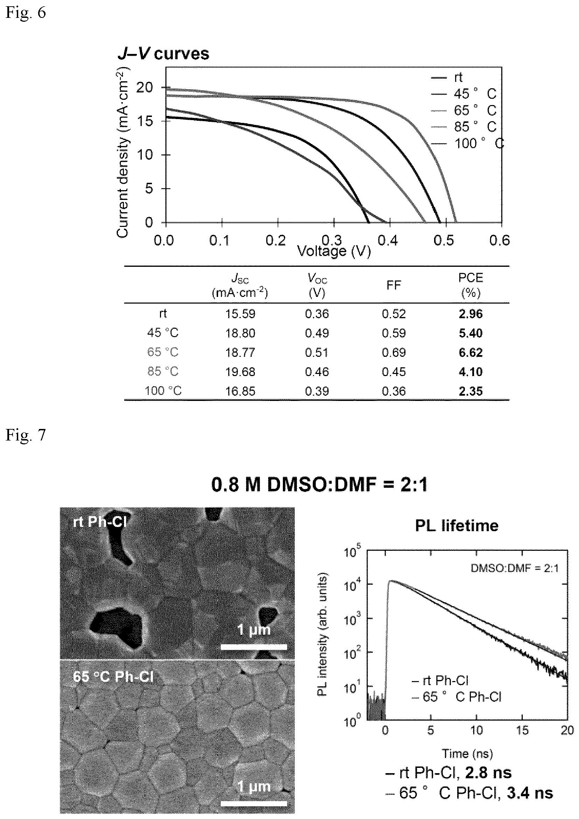

C₆₀ (50 nm (rate: 0.1 angstrom/second 0 nm to 10 nm, 0.2 angstrom/second 10 nm to 20 nm, 0.5 to 1.0 angstrom/second 20 nm to 50 nm)), BCP (8 nm (rate: 0.1 to 0.2 angstrom/second 0 nm to 8 nm)), Ag (100 nm (rate: 0.1 angstrom/second 0 nm to 10 nm, 0.2 angstrom/second 10 nm to 20 nm, 0.5 to 1.0 angstrom/second 20 nm to 100 nm)) was laminated on the perovskite film obtained in the test examples 5 by vacuum deposition to produce the Sn perovskite solar cell element. The solar cell characteristic (J-V) of these solar cell elements was evaluated under an inert gas atmosphere. The results are shown in Fig. 6. Fig. 6 is a diagram indicating a solar cell characteristic. In the graph at the upper portion of Fig. 6, the voltage values at the points where the current density is 0 shows the voltages at rt (room temperature), 100°C, 85°C, 45°C, and 65°C from the lowest voltage value. Among the obtained solar cell elements, the perovskite layers prepared by dropping chlorobenzene at 45°C, 65°C, 85°C were confirmed to have improved efficiency compared with the one prepared at room temperature. A decrease in efficiency was observed in the perovskite layer prepared by dropping chlorobenzene at 100°C and it is likely that the PEDOT:PSS layer as the base coat was damaged (partially dissolved).

From this, the temperature of chlorobenzene to be dropped is preferably 45°C to 100°C, more preferably 50°C to 85°C, and from the viewpoint of causing less damage to the base coat layer (PEDOT:PSS) of the perovskite layer, particularly preferably 50°C to 70°C. This method was effective not only when using a DMSO solvent but also when using various solvents such as a DMF mixed solvent and a DMF solvent as the perovskite solution.

### Test Example 7: Temperature Effect of Poor Solvent in DMSO/DMF = 2/1 Mixed Solvent

Inside a glove box, SnI₂ (298 mg, 0.8 mmol), FAI (103 mg, 0.6 mmol), MAI (32 mg, 0.2 mmol), SnF₂ (13 mg, 0.08 mmol) were dissolved in super-dehydrated DMSO (667 µL) and super-dehydrated DMF (333 µL) at 45°C. After stirring for one hour at 45°C, the solution was filtered using a PTFE filter to prepare a 0.8 M solution of FA_{0.75}MA_{0.25}SnI₃. Then, 200 µL of this solution was placed on the PEDOT:PSS substrate and spin-coated (slope 5 seconds, 5,000 rpm for 60 seconds, slope 1 second). When 300 µL of chlorobenzene at room temperature or warmed to 65°C using a hot plate was dropped after 58 seconds at 5,000 rpm, the perovskite layer turned brown. Then, the obtained brown film was placed on a hot plate and annealed (10 minutes at 45°C, >10 minutes at 65°C, 10 minutes at 100°C) to obtain a black perovskite film.

Fig. 7 indicates a SEM photograph and measuring results of a fluorescence lifetime in the test example 7. The upper left in Fig. 7 indicates the SEM photograph at room temperature and the down left in Fig. 7 indicates the SEM photograph at 65°C. In the graph on the right side, the graph located at the lower portion is the one at room temperature. As shown in Fig. 7, when the SEM observation of the obtained film was performed, many defects were observed in the perovskite layer prepared by dropping chlorobenzene at room temperature. Meanwhile, the perovskite layer prepared by dropping chlorobenzene at 65°C had the high flatness and the high coverage. When the fluorescence lifetime was measured for each film, the fluorescence lifetime of the perovskite layer prepared by dropping chlorobenzene at room temperature was 2.8 nanoseconds, whereas the fluorescence lifetime of the perovskite layer prepared by dropping chlorobenzene at 65°C was 3.4 nanoseconds, which was slightly longer.

### Test Example 8: Temperature Effect of Poor Solvent in DMSO/DMF = 1/2 Mixed Solvent

Inside a glove box, SnI₂ (298 mg, 0.8 mmol), FAI (103 mg, 0.6 mmol), MAI (32 mg, 0.2 mmol), SnF₂ (13 mg, 0.08 mmol) were dissolved in super-dehydrated DMSO (333 µL) and super-dehydrated DMF (667 µL) at 45°C. After stirring for one hour at 45°C, the solution was filtered using a PTFE filter to prepare a 0.8 M solution of FA_{0.75}MA_{0.25}SnI₃. Then, 200 µL of this solution was placed on the PEDOT:PSS/ITO glass substrate and spin-coated (slope 5 seconds, 5,000 rpm for 60 seconds, slope 1 second). When 300 µL of chlorobenzene at room temperature or warmed to 65°C using a hot plate was dropped after 58 seconds at a rotation speed of 5,000 rpm, the perovskite layer turned brown. Then, the obtained brown film was placed on a hot plate and annealed (10 minutes at 45°C, >10 minutes at 65°C, 10 minutes at 100°C) to obtain a black perovskite film.

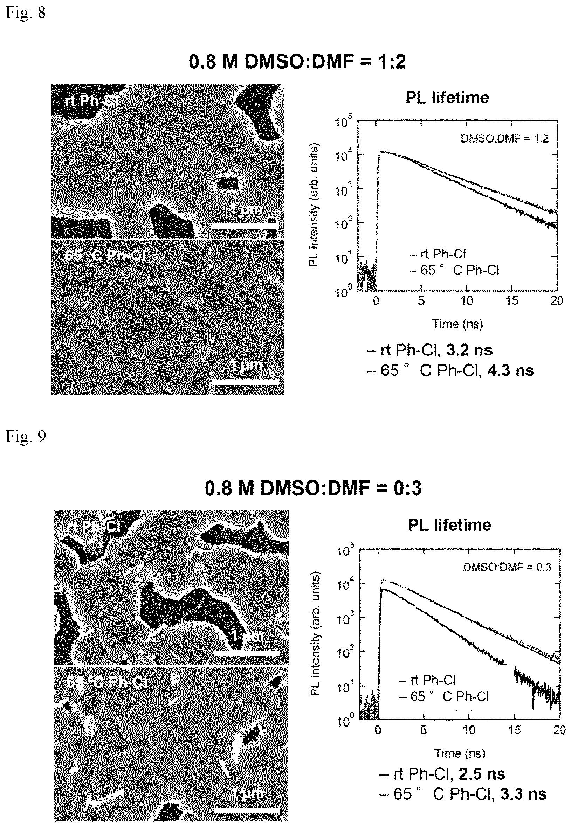

Fig. 8 indicates a SEM photograph and measuring results of a fluorescence lifetime in the test example 8. The upper left in Fig. 8 indicates the SEM photograph at room temperature and the down left in Fig. 8 indicates the SEM photograph at 65°C. In the graph on the right side, the graph located at the lower portion is the one at room temperature. When the SEM observation of the obtained film was performed, many defects in the perovskite layer prepared by dropping chlorobenzene at room temperature were observed. Meanwhile, the perovskite layer prepared by dropping chlorobenzene at 65°C had the high flatness and the high coverage. When the fluorescence lifetime was measured for each film, the fluorescence lifetime of the perovskite layer prepared by dropping chlorobenzene at room temperature was 3.2 nanoseconds, whereas the fluorescence lifetime of the perovskite layer prepared by dropping chlorobenzene at 65°C was 4.3 nanoseconds, which was slightly longer.

### Test Example 9: Temperature Effect of Poor Solvent in DMF Solvent

Inside a glove box, SnI₂ (298 mg, 0.8 mmol), FAI (103 mg, 0.6 mmol), MAI (32 mg, 0.2 mmol), SnF₂ (13 mg, 0.08 mmol) were dissolved in super-dehydrated DMF (1.0 mL) at 45°C. After stirring for one hour at 45°C, the solution was filtered using a PTFE filter to prepare a 0.8 M solution of FA_{0.75}MA_{0.25}SnI₃. Then, 200 µL of this solution was placed on the PEDOT:PSS/ITO glass substrate and spin-coated (slope 5 seconds, 5,000 rpm for 60 seconds, slope 1 second). When 300 µL of chlorobenzene at room temperature or warmed to 65°C using a hot plate was dropped after 58 seconds at a rotation speed of 5,000 rpm, the perovskite layer turned brown. Then, the obtained brown film was placed on a hot plate and annealed (10 minutes at 45°C, >10 minutes at 65°C, 10 minutes at 100°C) to obtain a black perovskite film.

Fig. 9 indicates a SEM photograph and measuring results of a fluorescence lifetime in the test example 9. The upper left in Fig. 9 indicates the SEM photograph at room temperature and the down left in Fig. 9 indicates the SEM photograph at 65°C. In the graph on the right side, the graph located at the lower portion is the one at room temperature. When the SEM observation of the obtained film was performed, many defects were observed in the perovskite layer prepared by dropping chlorobenzene at room temperature, and simultaneously, precipitation of SnF₂ on the perovskite film was verified. Meanwhile, the perovskite layer prepared by dropping chlorobenzene at 65°C had the relatively high flatness and the relatively high coverage. Similarly to the perovskite layer prepared by dropping chlorobenzene at room temperature, precipitation of SnF₂ on the perovskite film was verified. When the fluorescence lifetime was measured for each film, the fluorescence lifetime of the perovskite layer prepared by dropping chlorobenzene at room temperature was 2.5 nanoseconds, whereas the fluorescence lifetime of the perovskite layer prepared by dropping chlorobenzene at 65°C was 3.3 nanoseconds, which was slightly longer.

### Test Example 10: Highest Device Efficiency When Using Chlorobenzene at 65°C

Inside a glove box, SnI₂ (671 mg, 1.8 mmol; Aldrich), FAI (232 mg, 1.35 mmol), MAI (72 mg, 0.45 mmol), SnF₂ (28 mg, 0.18 mmol) were dissolved in super-dehydrated DMSO (2.0 mL) at 45°C. After stirring for 30 minutes, the solution was filtered using a PTFE filter to prepare a solution of FA_{0.75}MA_{0.25}SnI₃. Then, 200 µL of this solution was placed on the PEDOT:PSS/ITO glass substrate and spin-coated (slope 5 seconds, 5,000 rpm for 60 seconds, slope 1 second). After 58 seconds at a rotation speed of 5,000 rpm, 300 µL of chlorobenzene warmed to 65°C using a hot plate was dropped. Then, the obtained film was annealed (10 minutes at 45°C, >10 minutes at 65°C, 10 minutes at 100°C) to obtain a black perovskite film. When the SEM observation of the obtained film was performed, the high coverage was observed. C₆₀ (50 nm (rate: 0.1 angstrom/second 0 nm to 10 nm, 0.2 angstrom/second 10 nm to 20 nm, 0.5 to 1.0 angstrom/second 20 nm to 50 nm)), BCP (8 nm (rate: 0.1 to 0.2 angstrom/second 0 nm to 8 nm)), Ag (100 nm (rate: 0.1 angstrom/second 0 nm to 10 nm, 0.2 angstrom/second 10 nm to 20 nm, 0.5 to 1.0 angstrom/second 20 nm to 100 nm)) was laminated on the obtained perovskite film by vacuum deposition to produce the Sn perovskite solar cell element.

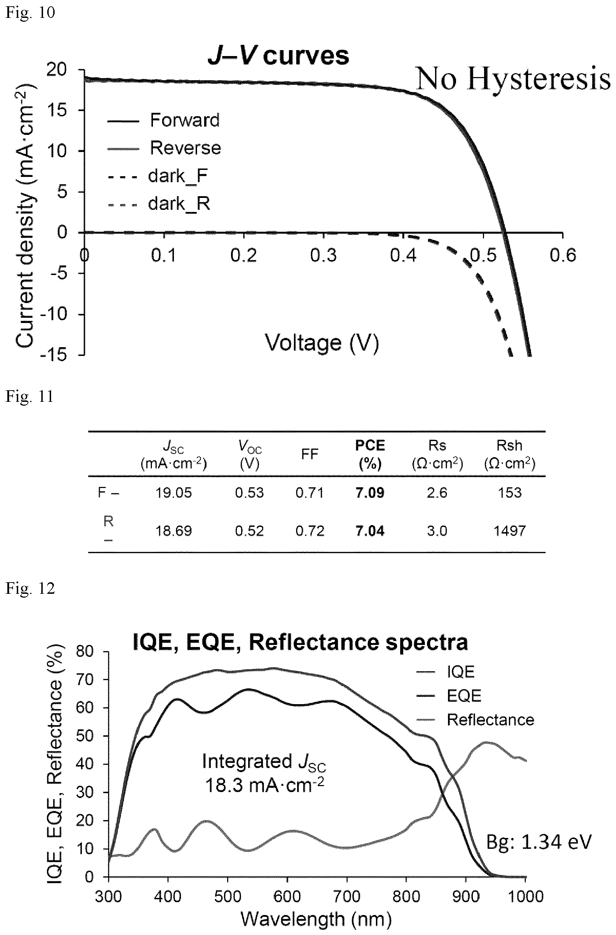

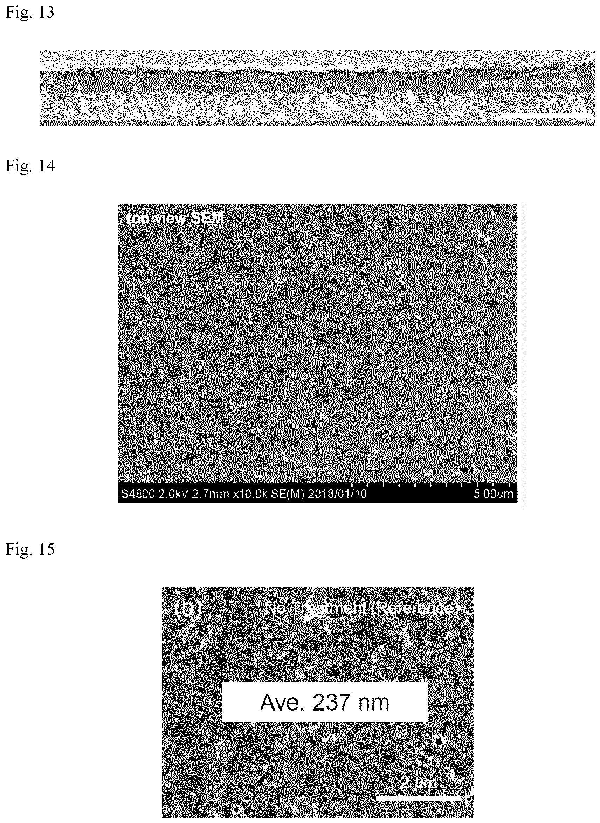

In the obtained perovskite solar cell, the current density-voltage characteristic was measured. Fig. 10 is a graph that replaces a drawing indicating the current density-voltage characteristic in the test example 10 (working example). Fig. 11 is a table indicating the characteristic of the perovskite solar cell. A short circuit current density Jsc = 19.05 mA cm⁻², an open circuit voltage Voc = 0.53V, a fill factor FF= 0.71, and the photoelectric conversion efficiency (PCE) was 7.09%. An action spectrum (EQE spectrum) of the obtained perovskite solar cell was measured. Fig. 12 is a graph that replaces a drawing indicating IQE spectrum and EQE spectrum. From the upper portion of the graph, IQE, EQE, and the reference are indicated. The short circuit current density (Jsc) obtained from the EQE spectrum was 18.3 mAcm⁻². The cross-sectional SEM images of the obtained solar cell was observed. The result is shown in Fig. 13. Fig. 13 is a cross-sectional SEM photograph of the solar cell obtained from the test example 10. The film thickness of the perovskite layer was 120 nm to 200 nm. Fig. 14 is a SEM photograph of the perovskite layer obtained from the test example 10. As shown in Fig. 14, this perovskite layer was filled with particles and flat.

### Test Example 11: Effect of DMSO Vapor Control during Annealing Process

A method 1: immediately after spin-coating the solution of FA_{0.75}MA_{0.25}SnI₃, a glass petri dish was placed on the substrate on a hot plate and annealed (10 minutes at 45°C, >10 minutes at 65°C). Subsequently, the petri dish was removed, and the annealing process was performed for 10 minutes at 100°C.

A method 2: on a hot plate, a plastic container containing 1 micro litter of DMSO was covered with a glass petri dish and waited for 2 minutes or more to prepare a saturated vapor environment of DMSO. Immediately after spin-coating the solution of FA_{0.75}MA_{0.25}SnI₃, the substrate was placed in a glass petri dish prepared on a hot plate and annealed at 45°C for 10 seconds or 30 seconds. Then, after moving it on another hot plate, only the substrate was covered with a new petri dish and annealed (10 minutes at 45°C, >10 minutes at 65°C). Subsequently, the petri dish was removed, and the annealing process was performed for 10 minutes at 100°C.

### Test Example 12: Effect of DMSO Vapor Control during Annealing Process (SEM)

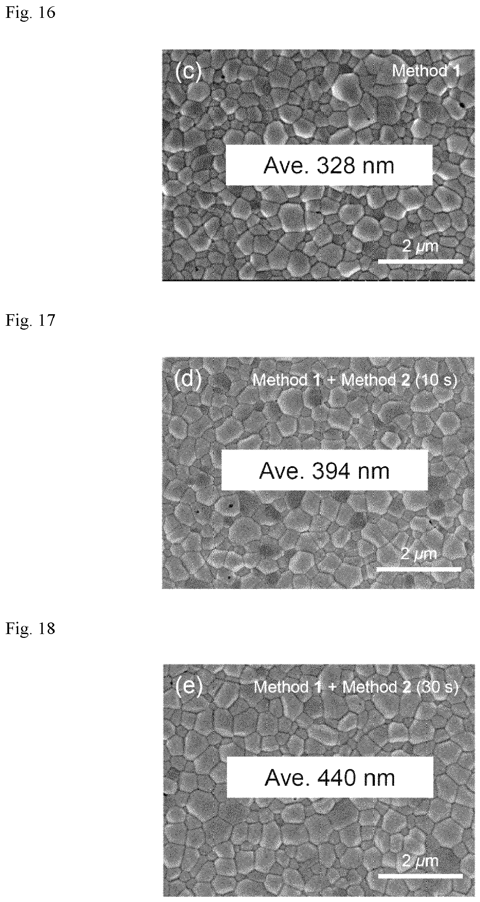

SEM observation for the obtained film was performed. Fig. 15 is a SEM image that replaces a drawing of an untreated one. Fig. 16 is a SEM image that replaces a drawing of the one of the method 1. Fig. 17 is a SEM image that replaces a drawing of the one of the method 1 + a method 2 (10 seconds). Fig. 18 is a SEM image that replaces a drawing of the one of the method 1 + the method 2 (30 seconds). Consequently, the film obtained by the method 1 showed improvement in a grain size compared with the untreated one (reference) (The average grain size estimated from the surface SEM image was 237 nm for reference and 328 nm for the method 1). Additionally, the film obtained by "the method 1 + the method 2 for 10 seconds" had a further improved grain size, and in the film obtained by "the method 1 + the method 2 for 30 seconds" had the largest average grain size (The average grain size was 394 nm for "the method 1 + the method 2 for 10 seconds", and 440 nm for "the method 1 + the method 2 for 30 seconds").

### Test Example 13: Effect of DMSO Vapor Control during Annealing Process and Solar Cell Measurement

C₆₀ (50 nm (rate: 0.1 angstrom/second 0 nm to 10 nm, 0.2 angstrom/second 10 nm to 20 nm, 0.5 to 1.0 angstrom/second 20 nm to 50 nm)), BCP (8 nm (rate: 0.1 to 0.2 angstrom/second 0 nm to 8 nm)), Ag (100 nm (rate: 0.1 angstrom/second 0 nm to 10 nm, 0.2 angstrom/second 10 nm to 20 nm, 0.5 to 1.0 angstrom/second 20 nm to 100 nm)) was laminated on each obtained perovskite film by vacuum deposition to produce the Sn perovskite solar cell element. The table below shows the results of comparing the efficiency of the devices.

**[Table 1]**

| Methods | | *J_{sc}* (mA/cm²) | *V_{oc}* (V) | Fill Factor | PCE (%) |
|---|---|---|---|---|---|
| Reference | Champion | 17.16 | 0.54 | 0.61 | 5.7 |
| | Average | 17.11±0.31 | 0.52±0.02 | 0.60±0.03 | 5.3±0.3 |
| Method 1 | Champion | 19.40 | 0.55 | 0.67 | 7.2 |
| | Average | 19.27±0.23 | 0.55±0.01 | 0.65±0.01 | 6.9±0.2 |
| Method 1 + 2 (10s) | Champion | 19.95 | 0.55 | 0.65 | 7.1 |
| | Average | 18.86±1.07 | 0.51±0.06 | 0.61±0.05 | 5.9±1.3 |
| Method 1 + 2 (30s) | Champion | 20.40 | 0.53 | 0.64 | 6.9 |
| | Average | 20.14±0.33 | 0.50±0.03 | 0.59±0.04 | 6.0±0.5 |

In the table, Method indicates the method, Reference indicates the reference, Champion indicates champion data (best data), and Average indicates an average (average value ± standard deviation).

### Test Example 14: Fluorescence Spectrum of Perovskite Film

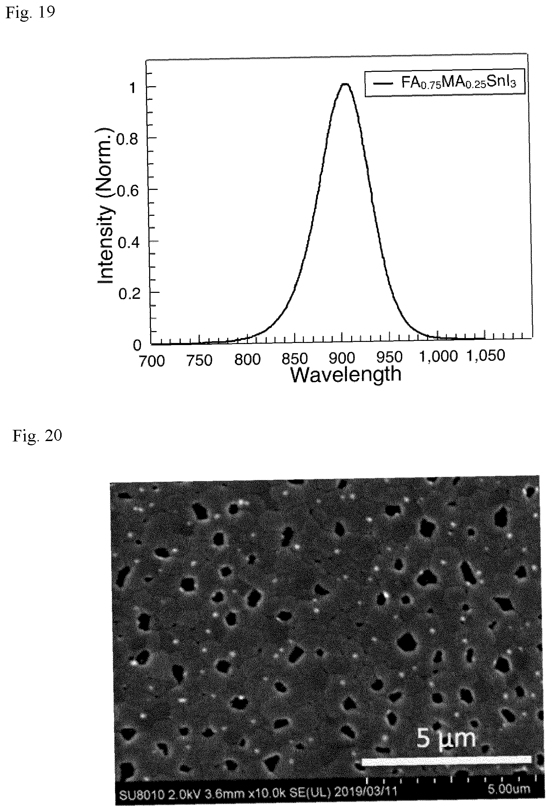

200 µL of a 0.8M DMSO solution of FA_{0.75}MA_{0.25}SnI₃ prepared in the same method as the test example 3 was placed on a quartz glass substrate and spin-coated (slope 5 seconds, 5,000 rpm for 60 seconds, slope 1 second). After 58 seconds at a rotation speed of 5,000 rpm, 350 µL of chlorobenzene warmed to 65°C was dropped during the spin coating. Then, the obtained film was placed on a hot plate and annealed (heated for 10 minutes at 45°C, heated for 10 minutes at 65°C, and heated for 10 minutes at 100°C) to obtain a perovskite film. Then, the fluorescence spectrum of the obtained perovskite film was measured (excitation light 510 nm). The fluorescence spectrum is shown in Fig. 19 (an emission peak wavelength 909.8 nm, FWHM (full width at half maximum) 274 meV). In Fig. 19, the horizontal axis is the wavelength (nm) and the vertical axis is the intensity (a maximum value is 1).

### Test Example 15: FASnBr₃ without HAT Method (rt, conventional method)

Inside a glove box, SnBr₂ (501.3 mg, 1.8 mmol), FABr (224.9 mg, 1.8 mmol), SnF₂ (28.2 mg, 0.18 mmol) were dissolved in super-dehydrated DMSO (2.0 mL) at 45°C. After stirring for 20 minutes at 45°C, the solution was filtered using a PTFE filter to prepare a FASnBr₃ precursor solution.

Approximately 200 µL thereof was applied onto a quartz glass substrate and spin-coated. During the spin coating, 300 µL of chlorobenzene at room temperature was dropped to obtain a yellow film (the slope was set to 5,000 rpm in 5 seconds, and chlorobenzene was dropped between the last 2 seconds and 1 second of spin coating that had been further performed for 60 seconds, and then it was stopped with the slope of 1 second (application and dropping similar to the above-described test example 14)). The obtained yellow film was annealed for 10 minutes at 45°C and for 10 minutes to 30 minutes at 65°C, and then annealed for 10 minutes at 100°C to prepare a yellow perovskite layer. The SEM image of the obtained FASnBr₃ perovskite film is shown in Fig. 20.

### Test Example 16: FASnBr₃ with HAT Method (65°C)

Inside a glove box, SnBr₂ (501.3 mg, 1.8 mmol), FABr (224.9 mg, 1.8 mmol), SnF₂ (28.2 mg, 0.18 mmol) were dissolved in super-dehydrated DMSO (2.0 mL) at 45°C. After stirring for 20 minutes at 45°C, the solution was filtered using a PTFE filter to prepare the FASnBr₃ precursor solution.

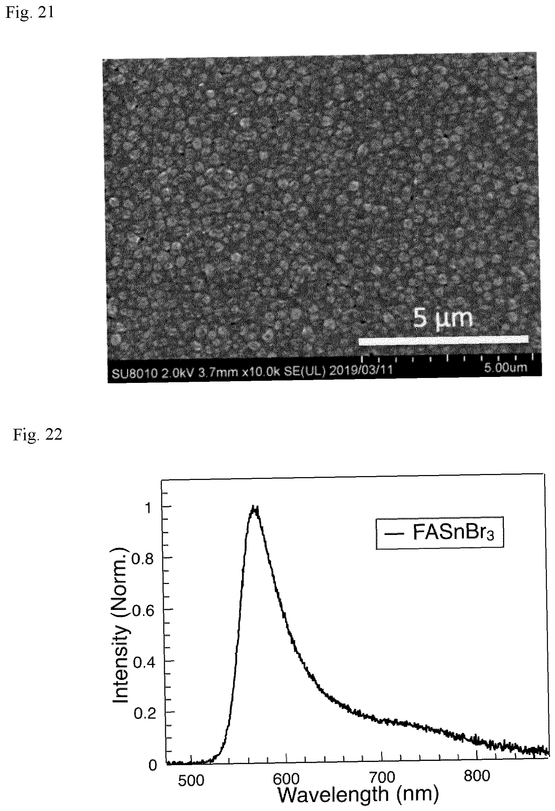

Approximately 200 µL thereof was applied onto a quartz glass substrate and spin-coated. During the spin coating, 300 µL of chlorobenzene warmed to 65°C was dropped to obtain a yellow film (the slope was set to 5,000 rpm in 5 seconds, and chlorobenzene was dropped between the last 2 seconds and 1 second of spin coating that had been further performed for 60 seconds, it was stopped with the slope of 1 second (application and dropping similar to the above-described test examples 14 and 15)). The obtained yellow film was annealed for 10 minutes at 45°C and for 10 minutes to 30 minutes at 65°C, and then annealed for 10 minutes at 100°C to prepare a yellow perovskite layer. The SEM image of the obtained FASnBr₃ perovskite film prepared by HAT method (dropping chlorobenzene at 65°C) is shown in Fig. 21.

When the SEM observation of the obtained film was performed, many defects were observed in the FASnBr₃ perovskite layer prepared by dropping chlorobenzene at room temperature. Meanwhile, the FASnBr₃ perovskite layer prepared by dropping chlorobenzene at 65°C had the high flatness and the high coverage.

The fluorescence spectrum of the obtained FASnBr₃ perovskite film (HAT method) was measured. The fluorescence spectrum (an excitation wavelength 444 nm, (excited emission peak wavelength 569.4 nm, FWHM (full width at half maximum) 201.7 meV) of the FASnBr₃ perovskite film (HAT method) is shown in Fig. 22. In Fig. 22, the horizontal axis is the wavelength (nm) and the vertical axis is the intensity (the maximum value is 1).

### Test Example 17: MASnBr₃ with HAT method (65°C)

Inside a glove box, SnBr₂ (501.3 mg, 1.8 mmol), MABr (201.6 mg, 1.8 mmol), SnF₂ (28.2 mg, 0.18 mmol) were dissolved in super-dehydrated DMSO (2.0 mL) at 45°C. After stirring for 20 minutes at 45°C, the solution was filtered using a PTFE filter to prepare a MASnBr₃ precursor solution.

Approximately 200 µL thereof was applied onto a quartz glass substrate and spin-coated. During the spin coating, 300 µL of chlorobenzene warmed to 65°C was dropped to obtain an orange film (the slope was set to 5,000 rpm in 5 seconds, and chlorobenzene was dropped between the last 2 seconds and 1 second of spin coating that had been further performed for 60 seconds, and then the spin coating was stopped with the slope of 1 second (application and dropping similar to the above-described test examples 14 to 16)). The obtained orange film was annealed for 10 minutes at 45°C and for 10 minutes to 30 minutes at 65°C, and then annealed for 10 minutes at 100°C to prepare an orange perovskite layer.

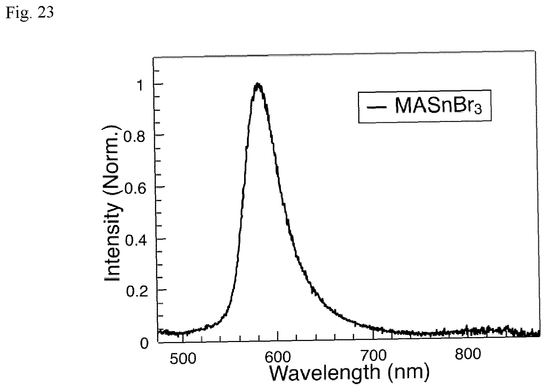

The fluorescence spectrum of the obtained MASnBr₃ perovskite film (HAT method) was measured. The fluorescence spectrum (the excitation wavelength 444 nm, (excited emission peak wavelength 582.9 nm, FWHM (full width at half maximum) 164.0 meV)) of the MASnBr₃ perovskite film (HAT method) is shown in Fig. 23. In Fig. 23, the horizontal axis is the wavelength (nm) and the vertical axis is the intensity (the maximum value is 1).

### Discussion

It has been shown that the above-described production method for the perovskite layer is useful for forming various Sn-based perovskite films, such as FAₓMA₁₋ₓSnI₃, FASnBr₃, MASnBr₃, and these can be used as a luminescent material. It has been shown that the perovskite layer prepared by the production method for the perovskite layer has a high coverage, and the perovskite layer having less defects can be obtained even when the thickness is reduced to, for example, 100 nm or less when using as a luminescent element.

Additionally, it has been shown that it is possible to apply it not only to the solar cell elements but also to the EL element where they are used as a luminescent material.

### INDUSTRIAL APPLICABILITY

Since the present invention relates to, for example, the production method for the perovskite layer, the present invention can be used in an industry for producing the solar cells and the organic EL elements.

## Claims

1. A method for producing a perovskite layer, comprising:
a step of applying a solution containing an Sn-based perovskite compound to a substrate;
a step of applying a poor solvent to the substrate; and
a step of performing an annealing process to the substrate, in this order, wherein
the poor solvent is at 45°C to 100°C.

2. The method according to claim 1, wherein
the poor solvent is at 50°C to 85°C.

3. The method according to claim 1, wherein
the poor solvent is at 50°C to 70°C.

4. The method according to claim 1, wherein
the poor solvent is applied by dropping the poor solvent while rotating the substrate, and
the rotation is stopped within 2.5 seconds to 7.5 seconds after the poor solvent is applied.

5. The method according to claim 1, wherein
the step of performing the annealing process includes a step of heating the substrate in stages in a sealed system containing a solvent vapor.

6. A method for producing a perovskite layer, comprising:
a step of applying a solution containing an Sn-based perovskite compound to a substrate;
a step of applying a poor solvent to the substrate; and
a step of performing an annealing process to the substrate, in this order, wherein the poor solvent is at room temperature or higher, thereby formation of a seed crystal is facilitated and crystal growth from the seed crystal is reduced.

7. A method for producing a perovskite layer, comprising:
a step of applying a solution containing an Sn-based perovskite compound to a substrate;
a step of applying a poor solvent to the substrate; and
a step of performing an annealing process to the substrate, in this order, wherein
a coverage of the perovskite layer with the Sn-based perovskite compound is 98% to 100%.

8. The method according to claim 7, wherein
an average particle diameter of the perovskite compound is 150 nm to 500 nm.

9. A production method for a perovskite-type solar cell including the method according to claim 1.

10. A production method for a perovskite-type luminescent element including the method according to claim 1.

11. A perovskite layer having a coverage with an Sn-based perovskite compound of 95% to 100%.

12. The perovskite layer according to claim 11, wherein
an average particle diameter of the Sn-based perovskite compound is 150 nm to 500 nm.

13. A perovskite-type solar cell including the perovskite layer according to claim 11.

14. A perovskite-type luminescent element including the perovskite layer according to claim 11.
